# EUROPEAN PATENT SPECIFICATION

(11) **EP 3 462 278 B1**
(45) Date of publication and mention of the grant of the patent: **24.03.2021**
(21) Application number: 18196659.9
(22) Date of filing: 25.09.2018
(51) Int. Cl.: G06F 1/16, H01L 27/32, H01L 51/00, H01L 51/52, H01L 51/56

(54) **FLEXIBLE DISPLAY DEVICE AND METHOD FOR MANUFACTURING THE DEVICE**
FLEXIBLE ANZEIGEVORRICHTUNG UND VERFAHREN ZUR HERSTELLUNG DAVON
DISPOSITIF D'AFFICHAGE FLEXIBLE ET SON PROCÉDÉ DE FABRICATION

(30) Priority: 29.09.2017 KR 20170127711
(43) Date of publication of application: 03.04.2019
(73) Proprietor: LG Display Co., Ltd., Seoul, 07336 (KR)
(72) Inventor: CHO, Hangsup, Gyeonggi-do 10845 (KR); PARK, Seongeun, Gyeonggi-do 10845 (KR); SHIN, Woosup, Gyeonggi-do 10845 (KR); LEE, Hyeonwoo, Gyeonggi-do 10845 (KR); KIM, Bongchul, Gyeonggi-do 10845 (KR)
(74) Representative: Hibbert, Juliet Jane Grace

(56) References cited:
- US-A1- 2006 163 565
- US-A1- 2009 278 449
- US-A1- 2013 169 515
- US-A1- 2016 320 803
- US-A1- 2017 092 897

## Description

### Technical Field

The present disclosure relates to a flexible display device and a method for manufacturing the device. More particularly, the present disclosure relates to a rollable display device that is switchable between rolled and extended states, and a method for fabricating the device.

### Related Art

A display device applies to a variety of electronic devices such as TVs, mobile phones, notebooks and tablets. Therefore, studies are being continued to develop thinner, lighter and lower-power consuming display devices.

A typical example of the display device may include a liquid crystal display device (LCD), a plasma display panel device (PDP), a field emission display device (FED), an electro luminescence display device (ELD), an electro-wetting display device (EWD) and, an organic light-emitting display device (OLED), etc.

In such display devices, in order to prevent damage or breakage of built-in components and wiring therein, a display panel thereof is generally provided in a flat form and is driven in the flat state. As a result, an application of the flat type display device is limited.

To widen the application of the display device, a flexible display device having a flexible substrate made of flexible material has been proposed. By way of example, the flexible display device includes a bendable display device, a foldable display device, and a rollable display device.

However, in the conventional flexible display device, a substrate is made of a flexible material such as plastic to allow flexibility. Such a flexible substrate made of the plastic may be vulnerable to external physical impact. In addition, in order to obtain the substrate made of the flexible material, a laser lift-off process may be performed on a carrier substrate for the flexible substrate. In this case, when the uniformity of the laser irradiation is lowered, there is a problem that the substrate made of the soft material peels off together with the carrier substrate.

US 2013/169515, in accordance with its abstract, recites "A flexible display apparatus including: a first film including a first surface and a second surface that are opposite each other, and a first groove formed in the first surface, the first film having a first rigidity; a third film on the second surface of the first film; a fourth film facing the third film; an emission display unit between and encapsulated by the third film and the fourth film; and a second film on the fourth film and facing the first film, the second film having a second rigidity that is less than the first rigidity."

US 2006/163565, in accordance with its abstract, recites "A method of manufacturing an organic electroluminescent display device includes preparing an auxiliary substrate, which has a flat side; forming a first protective layer on the auxiliary substrate; forming an organic electroluminescent unit on the first protective layer; bonding a flexible main substrate onto the organic electroluminescent unit; and etching the auxiliary substrate to remove the same."

### SUMMARY

In a first aspect, there is provided a flexible display device as defined in claim 1.

In a second aspect, there is provided a method for manufacturing a flexible display device as defined in claim 7.

This Summary is provided to introduce a selection of concepts in a simplified form that are further described below in the Detailed Description. This Summary is not intended to identify all key features or essential features of the claimed subject matter, nor is it intended to be used alone as an aid in determining the scope of the claimed subject matter.

The present invention is intended to provide a flexible display device in which damage due to external physical impact thereto is reduced, and to provide a method for manufacturing the device.

Further, one embodiment not covered by the claims is intended to provide a flexible display device having a structure configured such that the device is produced without a laser lift-off process, and to provide a method for manufacturing the device.

The purposes of the present disclosure are not limited to the above-mentioned purposes. Other purposes and advantages of the present disclosure, as not mentioned above, may be understood from the following descriptions and more clearly understood from the embodiments of the present disclosure. Further, it will be readily appreciated that the objects and advantages of the present disclosure may be realized by features and combinations thereof as disclosed in the claims.

Aspects of an invention are defined in the appended independent claims.

### BRIEF DESCRIPTION OF THE DRAWINGS

Figure 1 shows an extended state, a partially-rolled state, and a fully-rolled state of a flexible display device according to the present invention.
Figure 2 is a cross-sectional view of a flexible display device according to the present invention.
Figure 3 shows an example of a cross section of a thin-film transistor array and an organic light-emitting element array of Figure 2.
Figure 4 is a top view of one example of a rolling-assisting film of Figure 2.
Figure 5 is an illustration of defects that may occur in a first comparative example with a structure that does not include a buffer substrate, unlike the example in Figure 2.
Figure 6 is an exemplary illustration of a defect that may occur in a second comparative example with a structure that does not include a support substrate, unlike the example of Figure 2.
Figure 7 is an illustration of how crack propagation is inhibited in a flexible display device according to the present invention.
Figure 8 is a cross-sectional view of a flexible display device according to another embodiment not covered by the claims.
Figure 9 shows a method of manufacturing a flexible display device according to the present invention.
Figures 10 to 16 illustrate cross sections of intermediate structures corresponding to method steps of Figure 9.

### DETAILED DESCRIPTIONS

For simplicity and clarity of illustration, elements in the figures are not necessarily drawn to scale. Like reference numbers in different figures denote the same or similar elements, and as such perform similar functionality. Also, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

Examples of various embodiments are illustrated and described further below. It will be understood that the description herein is not intended to limit the claims to the specific embodiments described. On the contrary, it is intended to cover alternatives and modifications as may be included within the scope of the appended claims.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the appended claims.

It will be understood that when an element or layer is referred to as being "connected to", or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

Spatially relative terms, such as "beneath," "below," "lower," "under," "above," "upper," and the like, may be used herein for ease of explanation to describe one element or feature's relationship to another elements or features as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented for example, rotated 90 degrees or at other orientations, and the spatially relative descriptors used herein should be interpreted accordingly.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises", "comprising", "includes", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of the associated listed items. Expression such as "at least one of' when preceding a list of elements may modify the entire list of elements and may not modify the individual elements of the list.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In the following description, numerous specific details are set forth in order to provide a thorough understanding of the present disclosure. The present disclosure may be practiced without some or all of these specific details. In other instances, well-known process structures and/or processes have not been described in detail in order not to unnecessarily obscure the present disclosure.

Hereinafter, a flexible display device according to the present invention will be described in detail with reference to the accompanying drawings.

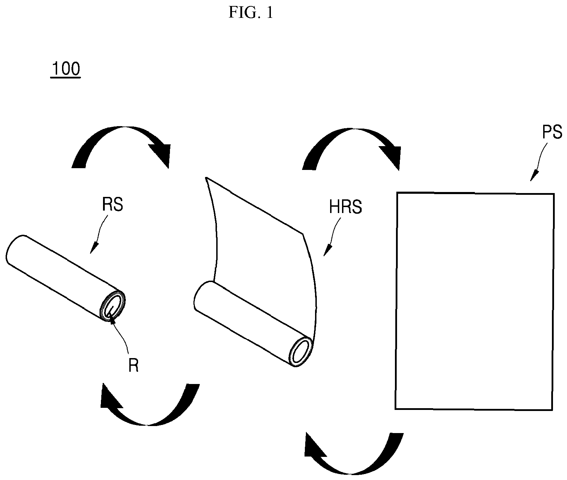

Figure 1 shows an extended state, a partially-rolled state, and a fully-rolled state of a flexible display device according to the present invention.

As illustrated in Figure 1, a flexible display device 100 in accordance with the present invention is embodied as a rollable display device switchable into between an extended form (PS; Plane-Shaped), a partially-rolled form (HRS; Half Rolling-Shaped), and a fully-rolled form (Rolled-Shaped: RS).

In this connection, when the device has the partially-rolled form (HRS; Half Rolling-Shaped), and the fully-rolled form (Rolled-Shaped: RS), the flexible display device 100 may be bent at a predetermined radius of curvature R.

To this end, the flexible display device 100 may be implemented with a structure including a substrate made of a flexible material.

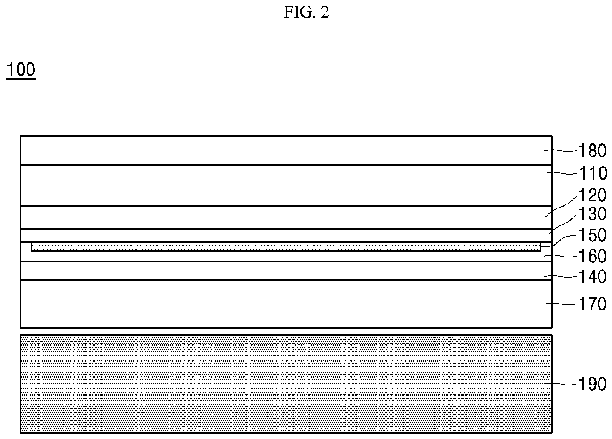

Figure 2 is a cross-sectional view of a flexible display device according to the present invention.

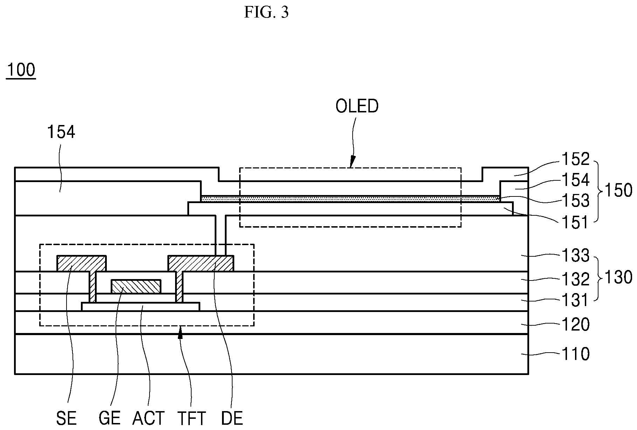

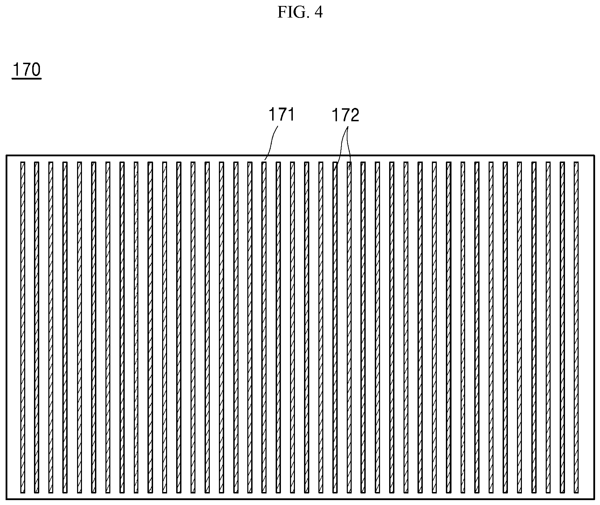

Figure 3 shows an example of a cross section of a thin-film transistor array and an organic light-emitting element array of Figure 2. Figure 4 is a top view of one example of a rolling-assisting film of Figure 2.

As illustrated in Figure 2, a flexible display device 100 according to the present invention includes a support substrate 110, a buffer substrate 120 disposed on one face of the support substrate 110, a thin-film transistor array 130 disposed on the buffer substrate 120, and a sealing substrate 140 disposed above the thin-film transistor array 130, wherein the thin-film transistor array 130 is disposed between the buffer substrate and the sealing substrate and is thus sealed by the sealing substrate.

Further, the flexible display device 100 further includes an organic light-emitting element array 150 disposed between the thin-film transistor array 130 and the sealing substrate 140; an adhesive film 160 for fixing the sealing substrate 140 on the organic light-emitting element array 150, wherein the adhesive film is disposed on one face of the sealing substrate; a rolling-assisting film 170 disposed on the other face of the sealing substrate 140; a polarization film 180 disposed on the other face of the support substrate 110.

Further, the flexible display device 100 may further include a bottom cover 190 corresponding to the extended state (PS in FIG. 1) thereof.

The support substrate 110 has a first thickness and is made of first material. In this connection, the first material may be selected as a material that transmits light and has low reactivity to processes such as etching and heat-treatment of semiconductor materials and metal materials. In addition, the first material may be selected as a material having a softness at a thickness below a threshold, while having a rigidity at a thickness exceeding the threshold value such that deformation thereof does not occur due to a weight thereof. Further, the first material may be selected as a material that may be subjected to an etching process and a polishing process to reduce the thickness thereof. In the present invention, the first material includes glass.

Further, the first thickness of the support substrate 110 may be selected in consideration of a softness of the first material, a damage resulting from a predetermined physical impact thereto, and a rigidity to maintain a shape and posture. By way of example, the first thickness may be between 50 µm inclusive and 100 µm inclusive. In particular, the first thickness may be about 80 µm.

The buffer substrate 120 has a second thickness smaller than the first thickness, and is made of a second material that is softer (i.e. more flexible) than the first material.

In the present invention, the second material is selected from a group consisting of PET (polyethylene terephthalate), PEN (ethylene naphthalate), PI (polyimide), PMMA (polymethyl methacrylate), PC (polycarbonate), PS (polystyrene), and PES polyethersulfone. In particular, the second material may be selected as a PI with relatively high availability.

The second thickness of the buffer substrate 120 may be selected to prevent the buffer substrate 120 from being lifted up, to suppress the transmittance degradation, and the crack transmission through the buffer substrate 120.

By way of example, when the second material is a PI, the second thickness may be in a range of 3 to 20 µm inclusive.

That is, when the thickness of the buffer substrate 120 is smaller than 3 µm, cracks in the thin-film transistor array 130 are easily transferred to the support substrate 110, and/or the cracks in the support substrate 110 are easily transferred to the thin-film transistor array 130 and the organic light-emitting element array 150.

On the other hand, when the thickness of the buffer substrate 120 is greater than 20 µm, bending stress may cause the buffer substrate 120 to easily be partly separated from or lift up from the support substrate 110 or the thin-film transistor array 130 in the rolled state (RS or HRS in FIG. 1). Further, the light transmittance of the device may be lowered due to the buffer substrate 120 having a thickness of greater than 20 µm.

The flexible display device 100 according to the present invention includes both the support substrate 110 having the first thickness and made of the first material, and the buffer substrate 120 having the second thickness and made of the second material. As a result, a predetermined radius of curvature (R in Figure 1) may be achieved in the rolled state (RS or HRS in Figure 1) thereof. By way of example, when the flexible display device 100 is in the rolled state (RS or HRS in Figure 1), the radius of curvature (R in Figure 1) may be between 40 mm and 3500 mm inclusive.

In addition, since the device includes both the support substrate 110 and the buffer substrate 120, the rigidity of the device against external physical impact may be improved. Further, cracks resulting from the external physical impact or bending stress may be prevented from being transmitted in the vertical direction. Thus, the life and reliability of the flexible display device 100 may be improved. Further, the present disclosure may prevent a dark spot defect resulting from the crack propagation, thereby preventing deterioration in image quality.

As illustrated in FIG. 3, the thin-film transistor array 130 defines a plurality of pixel regions corresponding to a plurality of sub-pixels. The array 130 includes at least one thin-film transistor TFT corresponding to each of a plurality of pixel regions.

Further, the organic light-emitting element array 130 includes a plurality of organic light-emitting element OLEDs corresponding to a plurality of sub-pixels.

By way of example, one thin-film transistor TFT provided in the thin-film transistor array 130 includes an active layer ACT disposed on a buffer substrate 120, a gate electrode GE disposed on a gate insulating film 131 covering an active layer ACT, and a source electrode SE and drain electrode DE disposed on a first interlayer insulating film 132 covering the gate electrode GE. Further, the source electrode SE and the drain electrode DE are covered with a second interlayer insulating film 133.

In this connection, the gate electrode GE is superimposed on a channel region of the active layer ACT. The source electrode SE is connected to a source region of the active layer ACT, while the drain electrode DE is connected to a drain region of the active layer ACT.

When the thin-film transistor TFT is implemented as a driving element for supplying driving current to the organic light-emitting element OLED, either the source electrode SE or the drain electrode DE of the thin-film transistor TFT is connected to the organic light-emitting element OLED.

The organic light-emitting element OLED is disposed on the second interlayer insulating film 133.

The organic light-emitting element OLED includes a first electrode 151 and a second electrode 152 facing each other, and an organic light-emitting layer 153 disposed between the first electrode 151 and the second electrode 152 facing each other.

Further, the organic light-emitting element array 150 may further include a bank layer 154 covering an edge of the first electrode 151.

Referring again to Figure 2, the polarization film 180 is configured to polarize light emitted from the organic light-emitting element array 150 and transmitted through the buffer substrate 120 and the support substrate 110. The polarization film 180 may suppress deterioration in image quality resulting from the external light.

By way of example, the polarization film 180 may have a thickness in a range of 170 µm to 650 µm.

The sealing substrate 140 may be fixed on the organic light-emitting element array 150 by the adhesive film 160 between the thin-film transistor array 130 and the sealing substrate 140. That is, while the buffer substrate 120 and the sealing substrate 140 sandwich, therebetween, the thin-film transistor array 130 and the organic light-emitting element array 150, the buffer substrate 120 and the sealing substrate 140 are bonded to each other via the adhesive film 160.

The rolling-assisting film 170 is intended to allow the flexible display device 100 to be deformed into a rolled form.

In the present invention, as illustrated in FIG. 4, the rolling-assisting film 170 includes at least one base 171 and a pattern of a plurality of ribs 172 disposed on the base 171 and spaced apart by a predetermined distance. In this connection, the ribs pattern 172 is disposed between a pair of bases 171.

The arrangement direction of the ribs of the rib pattern 172 corresponds to the rolling direction of the flexible display device 100. As shown in FIG. 4, when the device 100 is rolled along a long side of the flexible display device 100, an extending direction of each rib of the rib pattern is parallel to a short side of the device, and the arrangement direction of the ribs of the pattern is parallel to the long side.

As described above, the flexible display device 100 according to the present invention includes both the support substrate 110 made of a glass material, and a buffer substrate 120 made of a plastic material more flexible than the glass material.

Thus, the rigidity of the device against external physical impact may be improved. Further, cracks resulting from the external physical impact or bending stress may be prevented from being transmitted in the vertical direction. Thus, the life and reliability of the flexible display device may be improved. Further, the present disclosure may prevent a dark spot defect resulting from the crack propagation, thereby preventing deterioration in image quality.

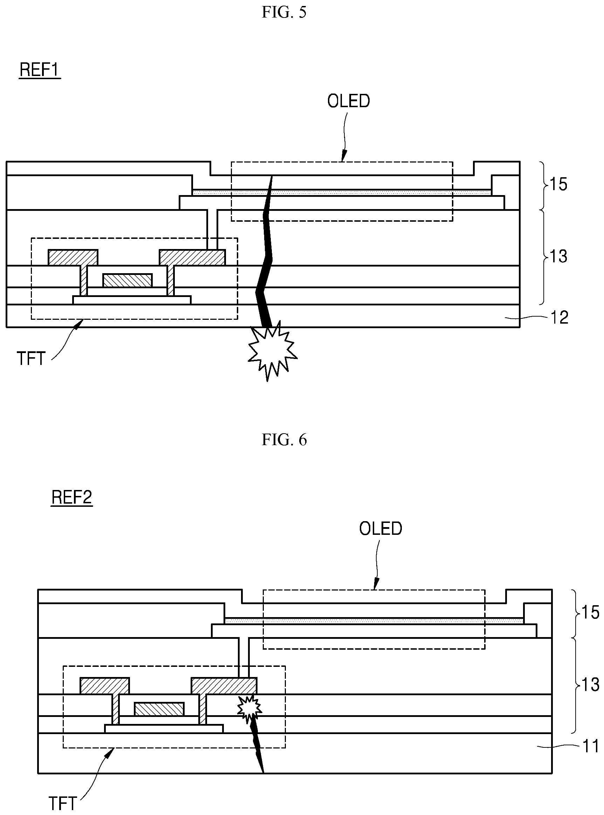

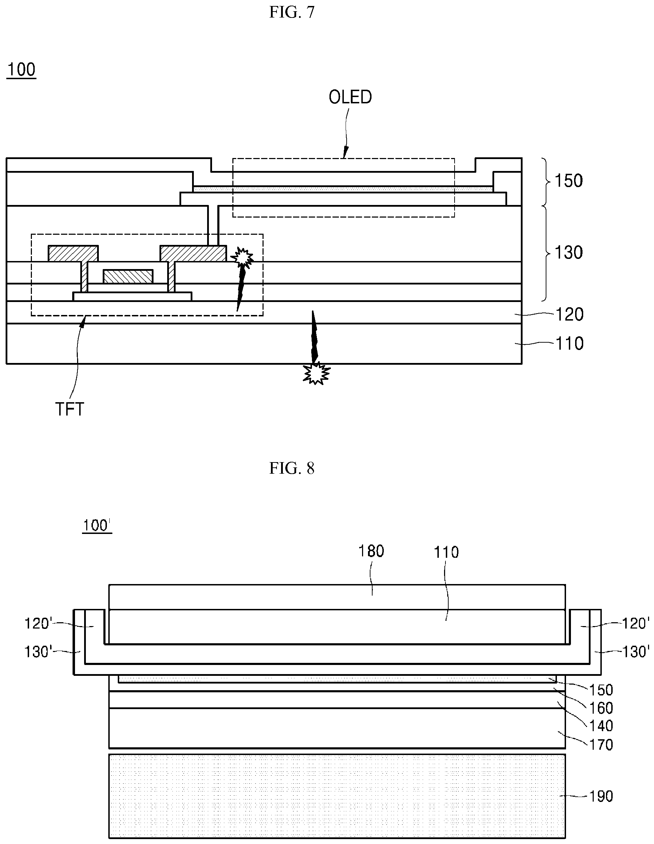

Figure 5 is an illustration of defects that may occur in a first comparative example with a structure that does not include a buffer substrate, unlike the example in Figure 2. Figure 6 is an exemplary illustration of a defect that may occur in a second comparative example with a structure that does not include a support substrate, unlike the example of Figure 2. Figure 7 is an illustration of how crack propagation is inhibited in a flexible display device according to the present invention.

As illustrated in Figure 5, the first comparative example REF1 includes only a buffer substrate 12 made of a plastic material, and excludes a support substrate made of a glass material.

In this case, since the device of the comparative example is susceptible or sensible to external physical impact, cracks resulting from the external physical impact easily occur in the thin-film transistor array 13 and the organic light-emitting element array 15. Particularly, when the crack dues resulting from the external physical impact is easily transmitted to the organic light-emitting element OLED. Thus, there is a problem in that the sub-pixel has a dark spot defect, which may result in deterioration in image quality or the lifespan.

In this first comparative example REF1, it has been experimentally confirmed that when a front-face striking strength is about 0. 22J to 1.08J, that is, when the average value of the front face striking strength is about 0.57J, the crack occurs therein.

On the other hand, as illustrated in Figure 6, the second comparative example REF2 contains only the support substrate 11 of the glass material, excluding the buffer substrate of the plastic material.

In this connection, the device of the second comparative example may have a higher rigidity against the external physical impact than the first comparative example of Figure 5. However, the device of the second comparative example has a problem that the cracks occurring in one substrate due to the bending stress is easily transferred to another substrate. That is, when a crack occurs in the insulating films disposed in the thin-film transistor array 13 and the organic light-emitting element array 15 due to the bending stress in the rolled state of the device, the occurred crack may be easily transferred to the support substrate 11 of the glass material, so that the crack may be visually recognized from the outside. As a result, there is a problem that deterioration of image quality, deterioration of aesthetic property, and deterioration of the life span may occur.

In this second comparative example REF2, it has been experimentally confirmed that when a front-face striking strength is about 0. 05J to 0.09J, that is, when the average value of the front face striking strength is about 0.06J, the crack occurs therein.

In contrast, as illustrated in Figure 7, the flexible display device 100 according to one embodiment of the present disclosure has both the support substrate 110 of a glass material and the buffer substrate 120 of a plastic material. As a result, defects otherwise resulting from external physical impact and bending stress may be suppressed in the present device.

That is, since the buffer substrate 120 may mitigate the external physical impact to be transmitted therefrom to the thin-film transistor array 130 and the organic light-emitting element array 150, cracks due to external physical impacts, thus leading to the black spot defects, may be reduced.

Further, cracking in the insulating film due to the bending stress may be prevented from transferring to the support substrate 110 of the glass material.

Further, in one embodiment of the present disclosure, it has been experimentally confirmed that when a front-face striking strength is about 0. 61J to 1.08J, that is, when the average value of the front face striking strength is about 0.92J, the crack occurs therein.

In other words, the flexible display device 100 according to the present invention maintains a normal state without the cracks occurring therein even when the device receives an impact strength greater by from about 1.6 times to about 15.3 times than those as applied to the first and second comparative examples as described above. As a result, the reliability and lifetime of the device may be improved.

In order to further reduce a bezel region in the flexible display device, various drive units may be disposed on the support substrate 110.

Figure 8 is a cross-sectional view of a flexible display device according to another embodiment not covered by the claims.

As illustrated in Figure 8, in a flexible display device 100' according to another embodiment of the present disclosure not covered by the claims, lateral side faces of the support substrate 110 face away the inner side faces of a buffer substrate 120'. Except for this configuration, a remaining configuration of this embodiment is the same as that of the present invention as illustrated in Figures 1 to 4. Therefore, the descriptions of the overlapping portions between the both embodiments may be omitted.

According to this embodiment not covered by the claims, a thin-film transistor array 130' is disposed on a first main face of the buffer substrate 120', while a support substrate 110' is disposed on an opposite main second face of the buffer substrate 120'. The lateral side faces of the support substrate 110 face away the inner side faces of the buffer substrate 120'. For this configuration, the buffer substrate 120' is partially (at side edges thereof) bent upward at an edge of the support substrate 110.

In addition, a portion of the thin-film transistor arrays 130' disposed on the buffer substrate 120 are disposed on the upwardly bending portion of the support substrate 110.

In this way, the non-display region may be extended to the side edge of the support substrate 110, so that the width of the bezel of the flexible display device 100' may be further reduced.

The following describes a method for producing a flexible display device according to the present invention.

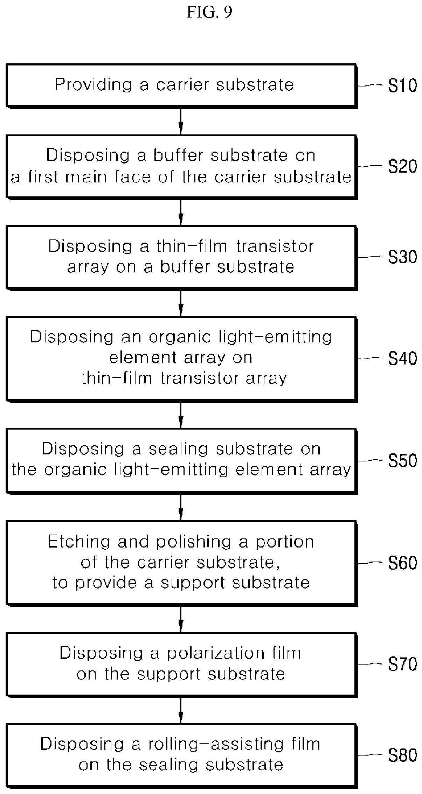

Figure 9 shows a method of manufacturing a flexible display device according to one embodiment of the present disclosure.

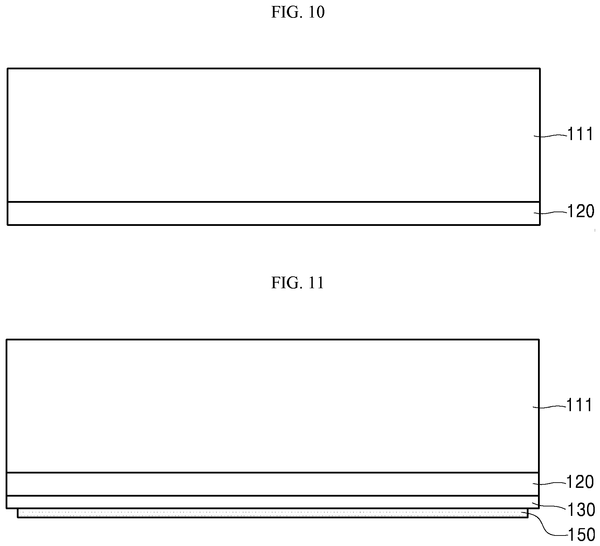

Figures 10 to 16 illustrate cross sections of intermediate structures corresponding to method steps of Figure 9.

As illustrated in Figure 9, a method for manufacturing a flexible display device according to the present invention includes a step S10 of providing a carrier substrate, a step S20 of disposing a buffer substrate on a first main face of the carrier substrate, a step S30 of disposing a thin-film transistor array on a buffer substrate, a step S40 of disposing an organic light-emitting element array on the thin-film transistor array, a step S50 of disposing a sealing substrate on the organic light-emitting element array, a step S60 of etching and polishing a portion of the carrier substrate, to provide a support substrate having a first thickness and contacting the buffer substrate, a step S70 of disposing a polarization film configured to polarize light emitted from the organic light-emitting element array on a main face of the support substrate opposite the buffer substrate, and a step S80 of disposing a rolling-assisting film promoting a formation of a rolled form on the sealing substrate.

As shown in Figure 10, a carrier substrate 111 made of a first material is provided (S10). Subsequently, a buffer substrate made of a second material more flexible than the first material is disposed on the carrier substrate 111 (S20).

In this connection, the first material may be selected as a material that transmits light and has low reactivity to processes such as etching and heat-treatment of semiconductor materials and metal materials.

In addition, the first material may be selected as a material having a softness at a thickness below a threshold, while having a rigidity at a thickness exceeding the threshold value such that deformation thereof does not occur due to a weight thereof. Further, the first material may be selected as a material that may be subjected to an etching process and a polishing process to reduce the thickness thereof. In the present invention, the first material includes glass.

Further, a thickness of the carrier substrate 111 may be selected within a range configured to allow the substrate to have a rigidity to such an extent that shape deformation of the substrate does not occur due to its own weight, and, to allow the substrate to have a weight that allows easy transportation thereof. By way of example, when the carrier substrate 111 is made of glass, the thickness of the carrier substrate 111 may be in a range of 400 to 700 µm.

The buffer substrate 120 is made of a second material that is softer than the first material. In the present invention, the second material is selected from a group consisting of PET (polyethylene terephthalate), PEN (ethylene naphthalate), PI (polyimide), PMMA (polymethyl methacrylate), PC (polycarbonate), PS (polystyrene), and PES polyethersulfone. In particular, the second material may be selected as a PI with relatively high availability.

The thickness of the buffer substrate 120 may be selected to prevent the buffer substrate 120 from being lifted up, to suppress the transmittance degradation, and the crack transmission through the buffer substrate 120. By way of example, when the second material is a PI, the thickness of the buffer substrate may be in a range of 3 to 20 µm inclusive.

As illustrated in FIG. 11, the thin-film transistor array 130 is disposed on the buffer substrate 120 (S30). Then, the organic light-emitting element array 150 is disposed on the thin-film transistor array 130 (S40).

As illustrated in FIG. 3, the thin-film transistor array 130 defines a plurality of pixel regions corresponding to a plurality of sub-pixels. The array 130 includes at least one thin-film transistor TFT corresponding to each of a plurality of pixel regions.

Further, the organic light-emitting element array 150 includes a plurality of organic light-emitting element OLEDs (as shown in FIG. 3) corresponding to a plurality of sub-pixels.

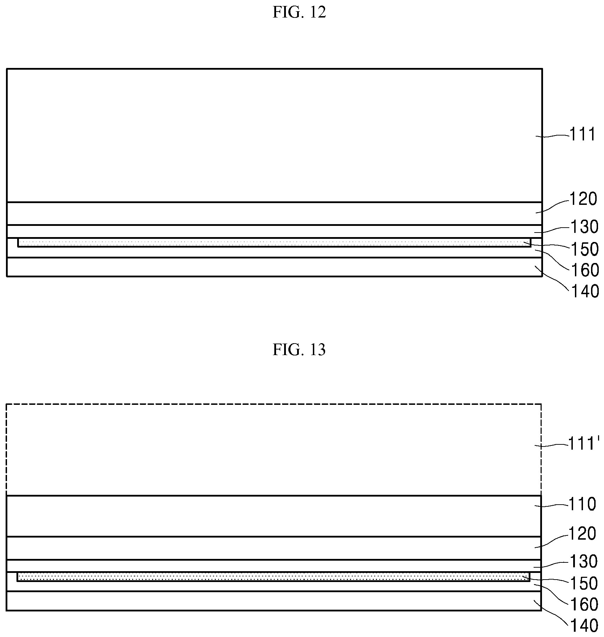

As illustrated in FIG. 12, the sealing substrate 140 is disposed on the organic light-emitting element array 150 so that the sealing substrate 140 faces away the buffer substrate 120 (S50).

As shown in Figure 12, the sealing substrate 140 may be fixed on the organic light-emitting element array 150 by the adhesive film 160 between the thin-film transistor array 130 and the sealing substrate 140. That is, while the buffer substrate 120 and the sealing substrate 140 sandwich, therebetween, the thin-film transistor array 130 and the organic light-emitting element array 150, the buffer substrate 120 and the sealing substrate 140 are bonded to each other via the adhesive film 160.

Further, as illustrated in Figure 13, a portion 111' of the carrier substrate is etched and polished to provide the support substrate 110 of a first thickness (S60).

As noted above, the buffer substrate 120 is disposed on a first main face of the carrier substrate 111. Thus, after providing the support substrate 110, the thin film transistor array 130 is disposed on a first main face of the buffer substrate 120, while the support substrate 111 is disposed on a second opposite main face of the buffer substrate 120.

In this connection, the first material may be selected as a material having a softness at a thickness below a threshold, while having a rigidity at a thickness exceeding the threshold value such that deformation thereof does not occur due to a weight thereof. Further, the first material may be selected as a material that may be subjected to an etching process and a polishing process to reduce the thickness thereof. In the present invention, the first material includes glass.

Further, the first thickness of the support substrate 110 may be selected in consideration of a softness of the first material, a damage resulting from a predetermined physical impact thereto, and a rigidity to maintain a shape and posture. By way of example, the first thickness may be between 50 µm inclusive and 100 µm inclusive. In particular, the first thickness may be about 80 µm.

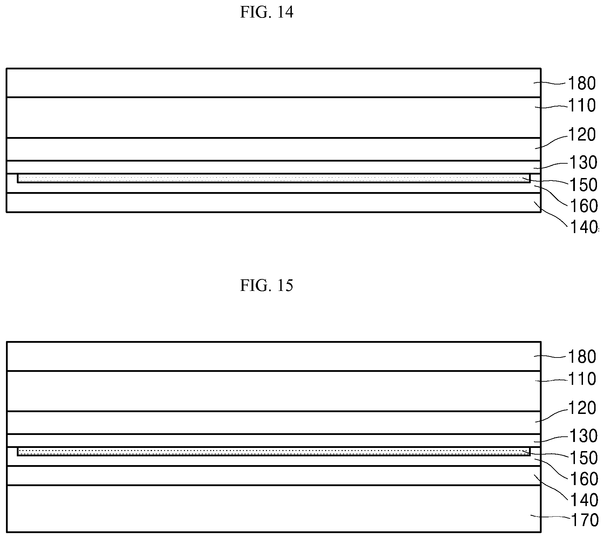

As illustrated in FIG. 14, the polarization film 180 is disposed on an exposed main surface of the support substrate 110 (S70).

In this connection, the polarization film 180 is configured to polarize light emitted from the organic light-emitting element array 150 and transmitted through the buffer substrate 120 and the support substrate 110. The polarization film 180 may suppress deterioration in image quality resulting from the external light. By way of example, the polarization film 180 may have a thickness in a range of 170 µm to 650 µm.

As illustrated in FIG. 15, the rolling-assisting film 170 is placed on an exposed main surface of the sealing substrate 140 (S80). The rolling-assisting film 170 is intended to allow the flexible display device 100 to be deformed into a rolled form. By way of example, as illustrated in FIG. 4, the rolling-assisting film 170 includes at least one base 171 and a pattern of a plurality of ribs 172 disposed on the base 171 and spaced apart by a predetermined distance. In this connection, the ribs pattern 172 is disposed between a pair of bases 171.

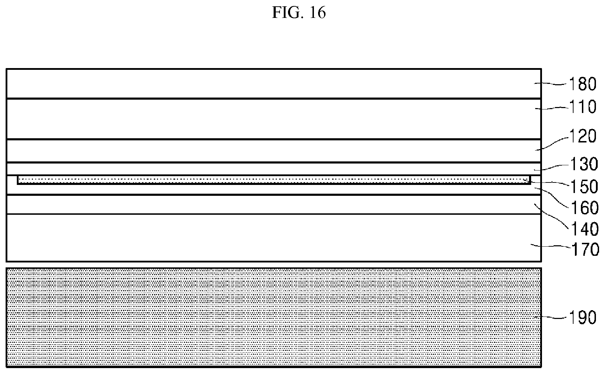

Further, as illustrated in FIG. 16, when the flexible display device 100 maintains the extended flat form, a display module DM may be housed in the bottom cover 190 corresponding to the flat form.

In this connection, the display module DM includes the polarization film 180, support substrate 110, buffer substrate 120, thin-film transistor array 130, organic light-emitting element array 150, adhesive film 160, sealing substrate 140, and rolling-assisting film 170.

In addition, although not separately illustrated in the drawings, a method of fabricating a flexible display device (100' in Figure 8) according to another embodiment of the present disclosure not covered by the claims may further include, after the step S70 in which the portion 111' of the carrier substrate is etched and polished to provide the support substrate 110 of the first thickness, a further step of removing an edge portion of the support substrate 110 to expose an edge region of the face of the buffer substrate 120 facing the support substrate 110; and a further step of bending the buffer substrate 120 such that the exposed edge portion of the buffer substrate 120 faces an outer lateral face of the support substrate 110.

In this manner, the method for fabricating the flexible display device according to one embodiment of the present disclosure not covered by the claims does not include a removal process of the carrier substrate 111 using a laser lift off (LLO) process. Therefore, damage of the buffer substrate 120 due to the laser lift off (LLO) process may be prevented. That is, the buffer substrate 120 may be prevented from peeling away or lifting up together with the carrier substrate 111, which otherwise may occur in a region where the laser is not uniformly irradiated due to foreign matter or cracks disposed in the surface of the carrier substrate 111. Thus, since the process defect of the flexible display device 100 may be reduced, the reliability and yield of the device may be improved.

In the above description, numerous specific details are set forth in order to provide a thorough understanding of the present disclosure. The present disclosure may be practiced without some or all of these specific details. Examples of various embodiments have been illustrated and described above. It will be understood that the description herein is not intended to limit the claims to the specific embodiments described. On the contrary, it is intended to cover alternatives and modifications as may be included within the scope of the appended claims.

## Claims

1. A flexible display device (100) comprising:
a support substrate (110) having a first thickness and made of a first material, wherein the support substrate (110) includes first and second faces which are opposite to each other;
a buffer substrate (120) disposed on the first face of the support substrate (110), wherein the buffer substrate (120) has a second thickness smaller than the first thickness and is made of a second material more flexible than the first material;
a thin-film transistor array (130) disposed on the buffer substrate (120), wherein the buffer substrate (120) is disposed between the thin-film transistor array (130) and the support substrate (110);
an organic light-emitting element array (150) disposed on the thin-film transistor array (130);
a sealing substrate (140) fixedly disposed on the organic light-emitting element array (150), wherein the thin-film transistor array (130) is disposed between the buffer substrate (120) and the organic light-emitting element array (150);
a polarization film (180) disposed on the second face of the support substrate (110); and
a rolling-assisting film (170) disposed on the sealing substrate (140), wherein the sealing substrate (140) is disposed between the rolling-assistant film (170) and thin-film transistor array (130), wherein the rolling-assistant film comprises a base (171) and a pattern of a plurality of ribs (172) disposed in the base (171) and spaced apart by a predetermined distance, wherein the ribs (172) are arranged in a direction corresponding to a rolling direction of the flexible display device (100),
wherein the first material includes glass, and
wherein the second material includes one selected from a group consisting of polyethylene terephthalate, PET, ethylene naphthalate, PEN, polyimide, PI, polymethyl methacrylate, PMMA, polycarbonate, PC, polystyrene, PS, and polyethersulfone, PES.

2. The device of claim 1, wherein the first thickness is between 50 µm inclusive and 100 µm inclusive.

3. The device of claim 1, wherein the second thickness is in a range of 3 µm to 20 µm inclusive.

4. The device of any preceding claim, wherein when the device (100) has a rolled form, a radius of curvature of the device is between 40 mm and 3500 mm inclusive.

5. The device of any preceding claim, wherein the organic light-emitting element array (150) includes a plurality of organic light-emitting elements corresponding to a plurality of sub-pixels respectively.

6. The device of claim 5, wherein the polarization film is configured to polarize light emitted from the organic light-emitting element array, wherein the polarization film has a thickness in a range of 170 µm to 650 µm inclusive.

7. A method for manufacturing a flexible display device (100), the method comprising:
providing a carrier substrate (111) made of a first material, wherein the carrier substrate includes first and second faces which are opposite to each other;
disposing a buffer substrate (120) on the first face of the carrier substrate, wherein the buffer substrate has a second thickness and is made of a second material more flexible than the first material;
disposing a thin-film transistor array (130) on the buffer substrate;
disposing an organic light-emitting element array (150) on the thin-film transistor array (130);
fixedly disposing a sealing substrate (140) on the organic light-emitting element array such that the thin-film transistor array and organic light-emitting element array are disposed and sealed between the buffer and sealing substrates;
etching and polishing a portion of the carrier substrate (111) from the second face thereof, to provide a remaining portion of the carrier substrate as a support substrate (110), wherein the support substrate has a first thickness greater than the second thickness;
disposing a polarization film (180) on a main face of the support substrate (110) opposite the buffer substrate (120), and
after etching of the carrier substrate, disposing a rolling-assistant film (170) on the sealing substrate, wherein the sealing substrate is disposed between the rolling-assistant film and the organic light-emitting element array (150), wherein the rolling-assistant film comprises a base (171) and a pattern of a plurality of ribs (172) disposed in the base (171) and spaced apart by a predetermined distance, wherein the ribs (172) are arranged in a direction corresponding to the rolling direction of the flexible display device (100),
wherein the first material includes glass, and
wherein the second material includes one selected from a group consisting of polyethylene terephthalate, PET, ethylene naphthalate, PEN, polyimide, PI, polymethyl methacrylate, PMMA, polycarbonate, PC, polystyrene, PS, and polyethersulfone, PES.

8. The method of claim 7, wherein the organic light-emitting element array includes a plurality of organic light-emitting elements corresponding to a plurality of sub-pixels respectively.

9. The method of claim 8, wherein the polarization film is configured to polarize light emitted from the organic light-emitting element array.

10. The method of any of claims 7 to 9, wherein the first thickness is between 50 µm inclusive and 100 µm inclusive.

11. The method of any of claim 7 to 10, wherein the second thickness is in a range of 3 µm to 20 µm inclusive.

## Patentansprüche

1. Flexible Anzeigevorrichtung (100), die umfasst:
ein Stützsubstrat (110), das eine erste Dicke aufweist und aus einem ersten Material besteht, wobei das Stützsubstrat (110) erste und zweite Flächen umfasst, die einander gegenüberliegen;
ein Puffersubstrat (120), das an der ersten Fläche des Stützsubstrat (110) angeordnet ist, wobei das Puffersubstrat (120) eine zweite Dicke, die kleiner als die erste Dicke ist, aufweist und aus einem zweiten Material, das flexibler als das erste Material ist, besteht;
eine Dünnschichttransistoranordnung (130), die an dem Puffersubstrat (120) angeordnet ist, wobei das Puffersubstrat (120) zwischen der Dünnschichttransistoranordnung (130) und dem Stützsubstrat (110) angeordnet ist;
eine organische Leuchtelementanordnung (150), die an der Dünnschichttransistoranordnung (130) angeordnet ist;
ein Dichtungssubstrat (140), das fest an der organischen Leuchtelementanordnung (150) angeordnet ist, wobei die Dünnschichttransistoranordnung (130) zwischen dem Puffersubstrat (120) und der organischen Leuchtelementanordnung (150) angeordnet ist;
eine Polarisationsschicht (180), die an der zweiten Fläche des Stützsubstrats (110) angeordnet ist; und
eine an dem Dichtungssubstrat (140) angeordnete Aufrollunterstützungsschicht (170), wobei das Dichtungssubstrat (140) zwischen der Aufrollunterstützungsschicht (170) und der Dünnschichttransistoranordnung (130) angeordnet ist, wobei die Aufrollunterstützungsschicht eine Basis (171) und eine Struktur aus mehreren Rippen (172) umfasst, die in der Basis (171) angeordnet und um einen vorbestimmten Abstand beabstandet sind, wobei die Rippen (172) in einer Richtung entsprechend einer Aufrollrichtung der flexiblen Anzeigevorrichtung (100) angeordnet sind,
wobei das erste Material Glas umfasst, und
wobei das zweite Material eines umfasst, das ausgewählt ist aus einer Gruppe bestehend aus Polyethylenterephthalat, PET, Ethylennaphthalat, PEN, Polyimid, PI, Polymethylmethacrylat, PMMA, Polycarbonat, PC, Polystyrol, PS, und Polyethersulfon, PES.

2. Vorrichtung nach Anspruch 1, wobei die erste Dicke zwischen einschließlich 50 µm und einschließlich 100 µm beträgt.

3. Vorrichtung nach Anspruch 1, wobei die zweite Dicke in einem Bereich von 3 µm bis einschließlich 20 µm liegt.

4. Vorrichtung nach einem der vorhergehenden Ansprüche, wobei, wenn die Vorrichtung (100) eine aufgerollte Form aufweist, ein Krümmungsradius der Vorrichtung zwischen 40 mm und einschließlich 3500 mm liegt.

5. Vorrichtung nach einem der vorhergehenden Ansprüche, wobei die organische Leuchtelementanordnung (150) eine Mehrzahl von organischen Leuchtelementen entsprechend jeweils einer Mehrzahl von Subpixeln umfasst.

6. Vorrichtung nach Anspruch 5, wobei die Polarisationsschicht ausgestaltet ist, von der organischen Leuchtelementanordnung emittiertes Licht zu polarisieren, wobei die Polarisationsschicht eine Dicke in einem Bereich von 170 µm bis einschließlich 650 µm aufweist.

7. Verfahren zum Herstellen einer flexiblen Anzeigevorrichtung (100), wobei das Verfahren umfasst:
Bereitstellen eines Trägersubstrats (111), das aus einem ersten Material besteht, wobei das Trägersubstrat erste und zweite Flächen umfasst, die einander gegenüberliegen;
Anordnen eines Puffersubstrats (120) an der ersten Fläche des Trägersubstrats, wobei das Puffersubstrat eine zweite Dicke aufweist und aus einem zweiten Material, das flexibler als das erste Material ist, besteht;
Anordnen einer Dünnschichttransistoranordnung (130) an dem Puffersubstrat;
Anordnen einer organischen Leuchtelementanordnung (150) an der Dünnschichttransistoranordnung (130);
festes Anordnen eines Dichtungssubstrats (140) an der organischen Leuchtelementanordnung derart, dass die Dünnschichttransistoranordnung und die organische Leuchtelementanordnung zwischen dem Puffer- und Dichtungssubstrat angeordnet und abgedichtet sind;
Ätzen und Polieren eines Teils des Trägersubstrats (111) von der zweiten Fläche davon, um einen verbleibenden Teil des Trägersubstrats als ein Stützsubstrat (110) bereitzustellen, wobei das Stützsubstrat eine erste Dicke aufweist, die größer als die zweite Dicke ist;
Anordnen einer Polarisationsschicht (180) an einer Hauptfläche des Stützsubstrats (110) gegenüber des Puffersubstrats (120); und
nach Ätzen des Trägersubstrats, Anordnen einer Aufrollunterstützungsschicht (170) an dem Dichtungssubstrat, wobei das Dichtungssubstrat zwischen der Aufrollunterstützungsschicht und der organischen Leuchtelementanordnung (150) angeordnet ist, wobei die Aufrollunterstützungsschicht eine Basis (171) und eine Struktur aus mehreren Rippen (172) umfasst, die in der Basis (171) angeordnet und um einen vorbestimmten Abstand beabstandet sind, wobei die Rippen (172) in einer Richtung entsprechend der Aufrollrichtung der flexiblen Anzeigevorrichtung (100) angeordnet sind,
wobei das erste Material Glas umfasst, und
wobei das zweite Material eines umfasst, das ausgewählt ist aus einer Gruppe bestehend aus Polyethylenterephthalat, PET, Ethylennaphthalat, PEN, Polyimid, PI, Polymethylmethacrylat, PMMA, Polycarbonat, PC, Polystyrol, PS, und Polyethersulfon, PES.

8. Verfahren nach Anspruch 7, wobei die organische Leuchtelementanordnung eine Mehrzahl von organischen Leuchtelementen entsprechend jeweils einer Mehrzahl von Subpixeln umfasst.

9. Verfahren nach Anspruch 8, wobei die Polarisationsschicht ausgestaltet ist, von der organischen Leuchtelementanordnung emittiertes Licht zu polarisieren.

10. Verfahren nach einem der Ansprüche 7 bis 9, wobei die erste Dicke zwischen einschließlich 50 µm und einschließlich 100 µm beträgt.

11. Verfahren nach einem der Ansprüche 7 bis 10, wobei die zweite Dicke in einem Bereich von 3 µm bis einschließlich 20 µm liegt.

## Revendications

1. Dispositif d'affichage souple (100) comprenant :
un substrat de support (110) ayant une première épaisseur et constitué d'un premier matériau, le substrat de support (110) comportant des première et deuxième faces qui sont à l'opposé l'une de l'autre ;
un substrat tampon (120) disposé sur la première face du substrat de support (110), le substrat tampon (120) ayant une deuxième épaisseur inférieure à la première épaisseur et étant constitué d'un deuxième matériau plus souple que le premier matériau ;
un réseau de transistors en couche mince (130) disposé sur le substrat tampon (120), le substrat tampon (120) étant disposé entre le réseau de transistors en couche mince (130) et le substrat de support (110) ;
un réseau d'éléments émetteurs de lumière organiques (150) disposé sur le réseau de transistors en couche mince (130) ;
un substrat de scellement (140) disposé de façon fixe sur le réseau d'éléments émetteurs de lumière organiques (150), le réseau de transistors en couche mince (130) étant disposé entre le substrat tampon (120) et le réseau d'éléments émetteurs de lumière organiques (150) ;
un film de polarisation (180) disposé sur la deuxième face du substrat de support (110) ; et
un film facilitant l'enroulement (170) disposé sur le substrat de scellement (140), le substrat de scellement (140) étant disposé entre le film facilitant l'enroulement (170) et le réseau de transistors en couche mince (130), le film facilitant l'enroulement comprenant une base (171) et un motif d'une pluralité de nervures (172) disposées dans la base (171) et espacées par une distance prédéterminée, les nervures (172) étant disposées dans une direction correspondant à une direction d'enroulement du dispositif d'affichage souple (100),
dans lequel le premier matériau comporte du verre, et dans lequel le deuxième matériau en comporte un choisi dans un groupe constitué par le téréphtalate de polyéthylène, PET, le naphtalate d'éthylène, PEN, le polyimide, PI, le polyméthacrylate de méthyle, PMMA, le polycarbonate, PC, le polystyrène, PS, et la polyéthersulfone, PES.

2. Dispositif de la revendication 1, dans lequel la première épaisseur se situe entre 50 µm inclus et 100 µm inclus.

3. Dispositif de la revendication 1, dans lequel la deuxième épaisseur se situe dans une gamme de 3 µm à 20 µm inclus.

4. Dispositif d'une quelconque revendication précédente dans lequel, quand le dispositif (100) a une forme enroulée, un rayon de courbure du dispositif se situe entre 40 mm et 3500 mm inclus.

5. Dispositif d'une quelconque revendication précédente, dans lequel le réseau d'éléments émetteurs de lumière organiques (150) comporte une pluralité d'éléments émetteurs de lumière organiques correspondant respectivement à une pluralité de sous-pixels.

6. Dispositif de la revendication 5, dans lequel le film de polarisation est configuré pour polariser la lumière émise depuis le réseau d'éléments émetteurs de lumière organiques, le film de polarisation ayant une épaisseur dans une gamme de 170 µm à 650 µm inclus.

7. Procédé de fabrication d'un dispositif d'affichage souple (100), le procédé comprenant :
l'obtention d'un substrat de départ (111) constitué d'un premier matériau, le substrat de départ comportant des première et deuxième faces qui sont à l'opposé l'une de l'autre ;
la disposition d'un substrat tampon (120) sur la première face du substrat de départ, le substrat tampon ayant une deuxième épaisseur et étant constitué d'un deuxième matériau plus souple que le premier matériau ;
la disposition d'un réseau de transistors en couche mince (130) sur le substrat tampon ;
la disposition d'un réseau d'éléments émetteurs de lumière organiques (150) sur le réseau de transistors en couche mince (130) ;
la disposition de façon fixe d'un substrat de scellement (140) sur le réseau d'éléments émetteurs de lumière organiques de telle sorte que le réseau de transistors en couche mince et le réseau d'éléments émetteurs de lumière organiques soient disposés et scellés entre les substrats tampon et de scellement ;
la gravure et le polissage d'une partie du substrat de départ (111) depuis la deuxième face de celui-ci, pour obtenir une partie restante du substrat de départ jouant le rôle d'un substrat de support (110), le substrat de support ayant une première épaisseur supérieure à la deuxième épaisseur ;
la disposition d'un film de polarisation (180) sur une face principale du substrat de support (110) à l'opposé du substrat tampon (120) ; et
après la gravure du substrat de départ, la disposition d'un film facilitant l'enroulement (170) sur le substrat de scellement, le substrat de scellement étant disposé entre le film facilitant l'enroulement et le réseau d'éléments émetteurs de lumière organiques (150), le film facilitant l'enroulement comprenant une base (171) et un motif d'une pluralité de nervures (172) disposées dans la base (171) et espacées par une distance prédéterminée, les nervures (172) étant disposées dans une direction correspondant à la direction d'enroulement du dispositif d'affichage souple (100),
dans lequel le premier matériau comporte du verre, et
dans lequel le deuxième matériau en comporte un choisi dans un groupe constitué par le téréphtalate de polyéthylène, PET, le naphtalate d'éthylène, PEN, le polyimide, PI, le polyméthacrylate de méthyle, PMMA, le polycarbonate, PC, le polystyrène, PS, et la polyéthersulfone, PES.

8. Procédé de la revendication 7, dans lequel le réseau d'éléments émetteurs de lumière organiques comporte une pluralité d'éléments émetteurs de lumière organiques correspondant respectivement à une pluralité de sous-pixels.

9. Procédé de la revendication 8, dans lequel le film de polarisation est configuré pour polariser la lumière émise depuis le réseau d'éléments émetteurs de lumière organiques.

10. Procédé de l'une quelconque des revendications 7 à 9, dans lequel la première épaisseur se situe entre 50 µm inclus et 100 µm inclus.

11. Procédé de l'une quelconque des revendications 7 à 10, dans lequel la deuxième épaisseur se situe dans une gamme de 3 µm à 20 µm inclus.
